# EUROPÄISCHE PATENTSCHRIFT

(11) **EP 2 933 836 B1**
(45) Veröffentlichungstag und Bekanntmachung des Hinweises auf die Patenterteilung: **14.10.2020**
(21) Anmeldenummer: 14164812.1
(22) Anmeldetag: 15.04.2014
(51) Int. Cl.: H01L 25/07, H01L 23/488

(54) **Leistungshalbleitermodul**
Power semiconductor module
Module semi-conducteur de puissance

(43) Veröffentlichungstag der Anmeldung: 21.10.2015
(73) Patentinhaber: IXYS Semiconductor GmbH, D-68623 Lampertheim (DE)
(72) Erfinder: Valente Seiroco, Hamilton, 69509 Mörlenbach (DE)
(74) Vertreter: Duxbury, Stephen

(56) Entgegenhaltungen:
- EP-A2- 1 713 124
- US-A1- 2007 138 624
- US-A1- 2012 104 621

## Beschreibung

Die Erfindung betrifft ein Leistungshalbleitermodul mit einem elektrische Kontaktflächen aufweisenden Träger, mindestens einem auf dem Träger angeordneten Leistungshalbleiterbauteil und mindestens zwei Kontaktelementen, die jeweils einen ersten und einen zweiten Ansatz aufweisen, die elektrisch mit einer Kontaktfläche des mindestens einen Leistungshalbleiterbauteils oder einer Kontaktfläche des Trägers verbunden sind. Die Erfindung bezieht sich insbesondere auf Halbleitermodule für höhere Leistungsanforderungen mit Dauergrenzströmen, die über 1 Ampere liegen können, wobei die aktiven Halbleiterchips und ggf. passiven Schaltungselemente sowie die internen wie externen Verbindungen auf flache, elektrisch isolierende Träger (Substrate) mittels Weichlöttechnik oder anderer geeigneter Verfahren aufgebracht werden, um elektrische Schaltungen zur Strom- und Spannungssteuerung bereit zu stellen.

Zu den bekannten Verfahren zur Kontaktierung von Halbleiterchips gehören beispielsweise Ultraschall-Schweißverfahren, bei denen Aluminium-Bonddrahtverbindungen mittels Ultraschallschweißen hergestellt werden. Anstelle von Aluminiumdrähten können auch Kupferbänder Anwendung finden (DE 10 2005 045 100 A1). Es sind auch mittels eines Laserschweißvorgangs hergestellte Verbindungen zwischen metallischen Kontaktflächen auf dem Substrat bekannt (DE 101 03 084 B4). Für Verbindungen nach außen werden auch Federkontakte eingesetzt (DE 103 16 355 B3), die aber für interne Verbindungen von Punkt zu Punkt weniger geeignet sind. Ultraschall-Drahtbondverbindungen können zwar sehr gut automatisiert werden, ein Nachteil ist aber die nahezu punktförmige Kontaktstelle auf den Chips bzw. der Substratmetallisierung, was die Stromtragfähigkeit lokal vermindert. Daher werden oft mehrere Bondkontakte parallel angebracht, was aber wegen der breiteren Ultraschall-Sonotroden wiederum größere Abstände zwischen den Kontakten und somit einen größeren Platzbedarf erfordert.

Alternativ sind schon seit langem Metallbügel bekannt, die vielfach aus Kupfer bestehen, das zur Verbesserung der Lötfähigkeit meist vernickelt ist. Diese sogenannten Clips werden mittels Weichlöttechnik und Lötformen montiert. Lötformen sind aber aufwendig herzustellen und für die Massenproduktion wegen manueller Bestückung weniger geeignet. Es sind auch lötformfreie Konstruktionen bekannt. Diese sind aber entweder nur für größere Bauteile verwendbar oder bei der Bestückung und während des Lötvorgangs schwierig in der nötigen Präzision zu handhaben.

Die EP 0 155 473 A1 beschreibt ein Leistungshalbleitermodul mit Kontaktelementen, die als sogenannte Clips ausgebildet sind. Die Kontaktbügel weisen an ihren flachen Fußenden kleine Öffnungen auf, die aber nur zur Aufnahme von Lot bestimmt sind.

Die sogenannte "Clip"-Technik hat sich in der Praxis nicht als vorteilhaft erwiesen, wenn sehr dichte Anordnungen, beispielsweise Reihenschaltungen, auf Substraten realisiert werden müssen, die gleichzeitig noch über eine ausreichende Stromtragfähigkeit verfügen sollen.

Darüber hinaus sind auch Lösungen mit stumpf ausgestalteten Clip-Enden bekannt, um platzsparende Anordnungen zu schaffen (DE 10 2005 016 650 A1). Diese haben aber den Nachteil, dass hohe Stromdichten an den Enden und seitliche Scherkräfte zu Zuverlässigkeitsproblemen führen können.

Die US 2007/0138624 A1 beschreibt ein Leistungshalbleitermodul, das einen elektrische Kontaktflächen aufweisenden Träger, ein auf dem Träger angeordnetes Leistungshalleiterbauteil und Kontaktelemente aufweist, deren Enden elektrisch mit einer Kontaktfläche des Leistungshalbleiterbauteils bzw. des Trägers verbunden sind. Eines der Kontaktelemente ist ein langgestrecktes Verbindungsstück, das an einem Ende zwei langgestreckte Abschnitte aufweist, während ein anderes Kontaktelement ein konventioneller Bonddraht ist. Die langestreckten Abschnitte des Verbindungsstücks sollen den Bonddraht seitlich umschließen, um den Bonddraht zu schützen, so dass dieser beim Vergießen nicht durch Kunstharz verformt oder beschädigt werden kann. Zur Herstellung der elektrischen Verbindung sind bei dem bekannten Leistungshalbleitermodul zwei Bonddrähte vorgesehen.

Der Erfindung liegt die Aufgabe zugrunde, die Nachteile der bekannten Kontaktierungsverfahren zu vermeiden und Kontaktelemente zu schaffen, die sowohl automatisiert verarbeitet werden können als auch bei dichter Bestückung auf Substraten den notwendigen Anforderungen an leichte Handhabbarkeit, große Zuverlässigkeit und hohe Stromtragfähigkeit genügen.

Die Lösung dieser Aufgabe erfolgt mit den Merkmalen des Anspruchs 1. Die abhängigen Ansprüche betreffen vorteilhafte Ausführungsformen der Erfindung.

Das erfindungsgemäße Leistungshalbleitermodul verfügt über einen elektrische Kontaktflächen aufweisenden Träger, mindestens ein auf dem Träger angeordnetes Leistungshalbleiterbauteil und mindestens zwei Kontaktelemente.

Die mindestens zwei erfindungsgemäßen Kontaktelemente weisen jeweils einen ersten und einen zweiten Ansatz auf, die elektrisch mit einer Kontaktfläche des mindestens einen Leistungshalbleiterbauteils oder einer Kontaktfläche des Trägers verbunden sind. Die Kontaktelemente können für sämtliche interne und externe Verbindungen zur Kontaktierung von aktiven Halbleiterchips und passiven Schaltungselementen dienen.

Jedes Kontaktelement weist ein langgestrecktes Verbindungsstück auf, an dessen Enden der erste und zweite Ansatz vorgesehen ist. Das langgestreckte Verbindungsstück mit dem ersten und zweiten Ansatz ist als ein flaches, gebogenes Metallstück ausgebildet.

Die Kontaktelemente sind derart auf dem Träger angeordnet und die Ansätze der Kontaktelemente sind derart ausgebildet, dass an einer Kontaktfläche des Leistungshalbleiterbauteils oder des Trägers der erste Ansatz des einen Kontaktelements von dem zweiten Ansatz des anderen Kontaktelements umfangsmäßig zumindest teilweise umschlossen wird. Dadurch wird eine besonders platzsparende elektrische Verbindung von jeweils zwei Kontaktelementen mit einer Kontaktstelle des Leistungshalbleiterbauteils oder des Trägers geschaffen, wobei die elektrische Verbindung mittels Weichlöten hergestellt werden kann. Anstelle einer Weichlötung kann für die elektrische Verbindung auch ein Ultraschall-Schweißverfahren eingesetzt werden. Aus der Anordnung der beiden Enden der Kontaktelemente in dichter Nachbarschaft ergibt sich eine hohe Stromtragfähigkeit. Die Handhabbarkeit wird dadurch vereinfacht, dass sich die Enden der Kontaktelemente vor der Herstellung der elektrischen Verbindung selbst justieren, in dem das eine Ende des einen Kontaktelements einen Anschlag für das andere Ende des anderen Kontaktelements bildet, da das eine Ende von dem anderen Ende zumindest teilweise umschlossen wird. Die Ansätze der Kontaktelemente sind mit der jeweiligen Kontaktfläche der strukturierten Metallisierung oder des Chips vorzugsweise verlötet. Bei einer Lötverbindung wird eine weitere Lot-Preform vermieden, die man sonst bei einer Überlappung der beiden Enden der Kontaktelemente benötigen würde.

Die jeweiligen Ansätze des Kontaktelement-Paars können unterschiedlich ausgebildet sein, solange der Ansatz des einen Kontaktelements von dem Ansatz des anderen Kontaktelements zumindest teilweise umschlossen wird.

Der erste und der zweite Ansatz sind an das langgestreckte Verbindungsstück nach einer Seite vorspringend angeformt sind, so dass zwischen dem Substrat und dem Verbindungsstück ein Abstand ist. Die gekröpften Ansätze erlauben die Überbrückung von bestimmten Bereichen auf dem Substrat.

Eine Ausführungsform der Erfindung sieht vor, dass die Ansätze der Kontaktelemente derart ausgebildet sind, dass der erste Ansatz des einen Kontaktelements in dem zweiten Ansatz des anderen Kontaktelements quer zur Längsrichtung des Kontaktelements seitlich fixiert ist. Damit ist sichergestellt, dass die Kontaktelemente bei der Montage nicht seitlich zueinander versetzt werden können, sondern auf einer Linie liegen. Zum Ausgleich von Bauteiltoleranzen sollte aber auch hier ein gewisses Spiel vorhanden sein. In Längsrichtung des Kontaktelements kann der erste Ansatz des einen Kontaktelements in dem zweiten Ansatz des zweiten Kontaktelements lose geführt sein, so dass sich die Kontaktelemente in Längsrichtung ausrichten lassen.

Bei einer bevorzugten Ausführungsform ist das langgestreckte Verbindungsstück mit dem ersten und zweiten Ansatz mit Weichlot beschichtet, so dass die Herstellung der elektrischen Verbindung vereinfacht wird.

Der erste Ansatz des Kontaktelements kann einen U-förmigen Querschnitt aufweisen. Der erste Ansatz kann aber anders ausgebildet sein. Entscheidend ist nur, dass er in den zweiten Ansatz des anderen Kontaktelements ohne zu Verklemmen passend eingesetzt werden kann.

Der zweite Ansatz des Kontaktelements ist vorzugsweise ein plattenförmiger oder tellerförmiger Ansatz, der flach auf der Kontaktfläche aufliegt und eine Ausnehmung aufweist, die den ersten Ansatz des anderen Kontaktelements aufnimmt. Vorzugsweise ist die Ausnehmung des zweiten Ansatzes eine rechteckförmige Ausnehmung. Die Ausnehmung kann aber auch beispielsweise rund oder oval sein. Eine runde Ausnehmung erlaubt die Anordnung der Kontaktelemente nicht nur auf einer Linie, sondern in einem weiten Winkelbereich zueinander. Beispielsweise können die benachbarten Kontaktelemente einen rechten Winkel einschließen.

Bei einer weiteren Ausführungsform ist der zweite Ansatz des Kontaktelements in der Art eines Mauls ausgebildet, das den ersten Ansatz des anderen Kontaktelements seitlich umschließt. Der maulförmige Ansatz kann einen sich nach außen verjüngenden Ausschnitt aufweisen, der den ersten Ansatz auch in Längsrichtung fixiert.

Der Kontaktflächen aufweisende Träger kann unterschiedlich ausgebildet sein. Vorzugsweise ist der Träger ein Substrat, das an mindestens einer Seite eine metallische Strukturierung aufweist, insbesondere ein beidseitig metallisiertes Keramiksubstrat, das in der DCB-Technik hergestellt sein kann. Der Träger kann aber auch ein metallischer Träger sein, der nicht über eine strukturierte Metallisierung verfügt, sondern zur Schaffung der Kontaktflächen gestanzt ist.

Das Leitungshalbleitermodul kann ein den Träger zumindest teilweise umschließendes Gehäuse aufweisen, aus dem Anschlüsse, beispielsweise Leistungs- und/oder Steueranschlüsse, herausgeführt sind, die mit einer Kontaktfläche des mindestens einen Leistungshalbleiterbauteils oder des Trägers elektrisch verbunden sind. Die erfindungsgemäßen Kontaktelemente können auch die seitlichen Anschlüsse bilden.

Nachfolgend werden unter Bezugnahme auf die Zeichnungen Ausführungsbeispiele des erfindungsgemäßen Leistungshalbleitermoduls näher beschrieben.

Es zeigen:
- Fig. 1: das erfindungsgemäße Kontaktelement des erfindungsgemäßen Leistungshalbleitermoduls in der Draufsicht,
- Fig. 2: einen Schnitt durch das Kontaktelement von Fig. 1,
- Fig. 3: der die Leistungshalbleiter tragende Träger des erfindungsgemäßen Leistungshalbleitermoduls, wobei die serielle Verschaltung mehrerer Leistungshalbleiter mit den erfindungsgemäßen Kontaktelementen gezeigt ist,
- Fig. 4: einen Ausschnitt von Fig. 3 in vergrößerter Darstellung,
- Fig. 5: das in einem Gehäuse gekapselte Leistungshalbleitermodul in der Draufsicht,
- Fig. 6: das Leistungshalbleitermodul von Fig. 5 in der Unteransicht,
- Fig. 7: eine alternative Ausführungsform des erfindungsgemäßen Kontaktelements mit einem maulförmigen Ansatz,
- Fig. 8: das Kontaktelement von Fig. 7 in der Draufsicht,
- Fig. 9: einen Schnitt durch das Kontaktelement von Fig. 7 und
- Fig. 10: der Träger mit den Leistungshalbleitern und den Kontaktelementen eines weiteren Ausführungsbeispiels des erfindungsgemäßen Leistungshalbleitermoduls.

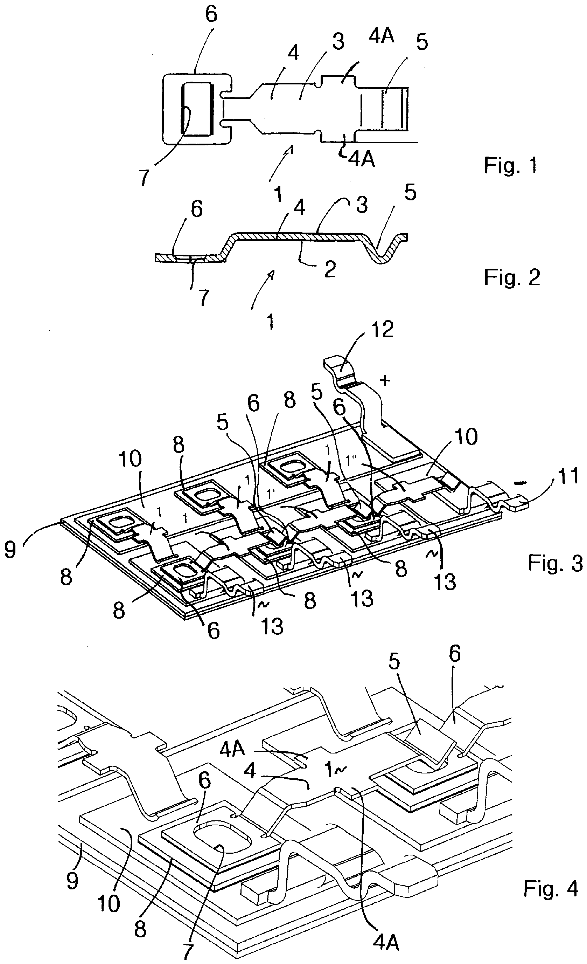

Die Figuren 1 und 2 zeigen das erfindungsgemäße Kontaktelement, mit dem die elektrischen Verbindungen in dem erfindungsgemäßen Leistungshalbleitermodul hergestellt werden, das in den Figuren 3 bis 6 gezeigt ist.

Das Kontaktelement 1 weist eine dem in den Figuren 1 und 2 nicht dargestellten Träger zugewandte Unterseite 2 und eine dem Träger abgewandte Oberseite 3 auf. Das Kontaktelement 1 ist als flaches, gebogenes Metallstück ausgebildet. Bei dem vorliegenden Ausführungsbeispiel ist das Metallstück aus einem einseitig mit Weichlot beschichteten Band aus Kupfer gestanzt, so dass die dem Träger zugewandte Unterseite 2 des Kontaktelements bereits lötbar ist. Folglich können beim Weichlöten separate Lotplättchen, die auch als Preform bezeichnet werden, entfallen. Die Dicke des Cu-Bandes kann beispielsweise 0,25 mm betragen. Es ist grundsätzlich auch eine elektrische Verbindung durch Ultraschallschweißen möglich, wobei dann eine einseitige Beschichtung mit Weichlot oder eine Vernickelung, die als Oxidationsschutz für die Verwendung von Lotplättchen zum Löten vorgesehen ist, nicht erforderlich ist.

Das gebogene Metallstück des Kontaktelements 1 weist ein langgestrecktes, bogenförmiges Verbindungsstück 4 auf, an dessen in den Figuren 1 und 2 rechtem Ende ein erster Ansatz 5 und an dessen linkem Ende ein zweiter Ansatz 6 angeformt ist. Beide Ansätze 5, 6 springen nach unten zurück, so dass das Kontaktelement 1 auf dem Substrat nur an den Ansätzen 5, 6 aufliegt. Damit können beispielsweise elektrische Isolierbereiche auf dem Substrat oder (glas-)passivierte Randbereiche von Chips überbrückt werden. An den beiden Seiten des Verbindungsstücks 4 befinden sich vorspringende Abschnitte 4A, die nach dem Freistanzen aus einem "Tape and Reel"-Band stehen geblieben sind.

Der erste Ansatz 5 ist bei dem vorliegenden Ausführungsbeispiel hakenförmig ausgebildet. Er kann aber auch plattenförmig oder stumpf sein. Bei dem vorliegenden Ausführungsbeispiel hat der erste Ansatz 5 einen U-förmigen Querschnitt, um mit einer lotfähigen Chipoberfläche kontaktiert werden zu können. Der erste Ansatz 5 kann auch flacher ausgebildet sein, um für eine Weichlötung eine größere Kontaktfläche zu schaffen.

Der zweite Ansatz 6 ist plattenförmig ausgebildet, wobei in dem plattenförmigen Ansatz 6 eine Ausnehmung 7 vorgesehen ist. Die Ausnehmung 7 ist bei dem vorliegenden Ausführungsbeispiel rechteckförmig. Die Breite des ersten Ansatzes 5 entspricht der Breite der Ausnehmung 7 des zweiten Ansatzes 6, so dass der erste Ansatz 5 eines Kontaktelements 1 in den zweiten Ansatz 6 eines anderen Kontaktelements 1 passend eingesetzt werden kann. Dabei sollte der erste Ansatz 5 in dem zweiten Ansatz 6 unter Berücksichtigung möglicher Toleranzen ein gewisses Spiel haben, so dass er nicht verklemmen kann.

Das erfindungsgemäße Leistungshalbleitermodul verfügt über mindestens zwei gleiche oder gleichartige Kontaktelemente 1, die sich durch die besondere Ausbildung der Ansätze 5, 6 auszeichnen. Die Figuren 3 und 4 zeigen die Verwendung der erfindungsgemäßen Kontaktelemente 1 in einem Leistungshalbleitermodul, das eine Drehstrombrückenschaltung aus sechs Leistungs-Dioden 8 umfasst.

Als Träger 9 dient eine beidseitig mittels DCB-Technik (Direct Copper Bonding) metallisierte Keramikplatte, beispielsweise aus Aluminiumoxid, deren Oberseite entsprechend dem erforderlichen Schaltungsmuster strukturiert ist. Die Figuren 3 und 4 zeigen, dass die Metallisierung 10 auf der Oberseite des Substrats 9 in Form von Leiterbahnen bzw. Kontaktflächen strukturiert ist. Die Dioden 8 sind auf dem Substrat 9 in zwei Reihen angeordnet, die jeweils auf einer Hälfte des Substrats liegen. Sie werden an der Ober- und Unterseite der Chips kontaktiert. Sämtliche elektrischen Verbindungen erfolgen mit gleichartigen Kontaktelementen 1.

Auf der Seite der Wechselspannungseingänge sind mehrere Kontaktelemente 1, 1', 1" in einer Reihe angeordnet, um den Minus-Pol der Brücke herzustellen. Dabei sitzt der erste Ansatz 5 des einen Kontaktelements 1 exakt in der Ausnehmung 7 des zweiten Ansatzes 6 des benachbarten Kontaktelements 1. Der plattenförmige Ansatz 6 des ersten Kontaktelements 1 kontaktiert die obere Kontaktfläche der ersten Diode 8 und der hakenförmige Ansatz 5 des ersten Kontaktelements 1 sitzt in der Ausnehmung 7 des plattenförmigen Ansatzes 6 des zweiten Kontaktelements 1', das die Kontaktfläche der zweiten Diode 8 kontaktiert. Der hakenförmige Ansatz 5 des zweiten Kontaktelements 1' sitzt wiederum in der Ausnehmung 7 des plattenförmigen Ansatzes 6 des dritten Kontaktelements 1", das die Oberseite der dritten Diode 8 kontaktiert. Dabei ist der hakenförmige Ansatz 5 des dritten Kontaktelements 1" elektrisch mit einer externen Anschlusslasche 11 für den Minus-Pol verbunden. Mit gleichartigen Kontaktelementen 1 werden auch weitere elektrische Verbindungen zu den anderen Dioden 8 hergestellt, wobei die Kontaktelemente aber nicht in einer Reihe angeordnet sind. Das Halbleitermodul verfügt noch über eine externe Anschlusslasche 12 für den Plus-Pol und weitere externe Anschlusslaschen 13 für die Wechselspannungsanschlüsse, die aus dem in den Figuren 3 und 4 nicht dargestellten Gehäuse 14 seitlich herausgeführt sind.

Die Anordnung und Ausbildung der Kontaktelemente 1 hat den Vorteil, dass sie platzsparend ist und gleichzeitig eine maximale Stromtragfähigkeit aufweist. Die Abstände zwischen den inneren Randbereichen der jeweils benachbarten Ansätze 5, 6 der Kontaktelemente 1 sind an der Verbindungsstelle sehr klein, was zu minimalen Übergangswiderständen führt. Darüber hinaus ist die Kontaktfläche zu den rechteckigen Chips durch die plattenförmigen vorzugsweise ebenfalls rechteckförmigen Ansätze 6 der Kontaktelemente 1 optimal ausgenutzt.

Das Substrat 9 mit den Halbleiterbauelementen 8 und Kontaktelementen 1 wird im Allgemeinen mittels Umpresstechnik verkapselt und die in Kammtechnik angebrachten Außenanschlüsse anschließend getrennt, was beispielsweise in der EP 1 976 358 A2 im Einzelnen beschrieben ist.

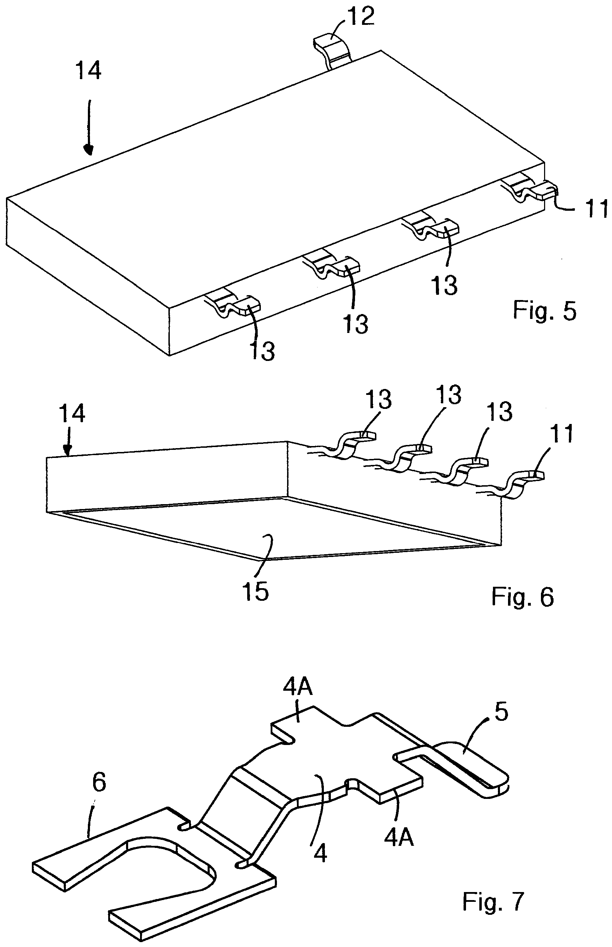

Fig. 5 zeigt das Gehäuse 14 des fertig umpressten Leistungshalbleitermoduls in der Draufsicht. Die Anschlusslaschen 11, 12, 13 sind seitlich aus dem Gehäuse herausgeführt. Die Anschlüsse der Anschlusslaschen 11, 12, 13 liegen auf der dem Substrat 9 gegenüberliegenden Seite des Gehäuses 14, sodass das Bauteil einfach in SMD-Technik beispielsweise auf eine Leiterplatte gelötet werden kann. Fig. 6 zeigt das gleiche Bauteil von der Unterseite, wobei die flache DCB-Fläche 15 an der Gehäuseunterseite für eine verbesserte Wärmeabfuhr an einen Kühlkörper angepresst werden kann. Es sind aber auch Ausführungsformen möglich, bei denen die Anschlusslaschen an der Oberseite des Gehäuses herausgeführt sind.

Die Figuren 7 bis 9 zeigen eine alternative Ausführungsform des Kontaktelementes 1, das sich von dem unter Bezugnahme auf die Figuren 1 und 2 beschriebenen Kontaktelement dadurch unterscheidet, dass dessen erster Ansatz 5 flach und dessen zweiter Ansatz 6 maulförmig ausgebildet ist. Die einander entsprechenden Abschnitte sind mit den gleichen Bezugszeichen versehen. Ein maulförmiger Ansatz 6 verhindert eine Bewegung des Ansatzes des benachbarten Kontaktelements quer zur Längsrichtung des Kontaktelements. Bei dem vorliegenden Ausführungsbeispiel weist der maulförmige Ansatz 6 einen sich nach außen verjüngenden Ausschnitt 6A auf, sodass ein Versatz aneinandergefügter Kontaktelemente auch in Längsrichtung vermieden wird. Der erste Ansatz 5 weist abgerundete Ecken auf, deren Kontur der Kontur des innenliegenden Abschnitts des Ausschnitts 6A des zweiten Ansatzes 6 entspricht. Somit passt der erste Ansatz 5 des einen Kontaktelements 1 genau in den zweiten Ansatz 6 des anderen Kontaktelements 1. Mit der größeren Auflagefläche des ersten Ansatzes 5 wird der Kontakt zu dem Substrat 9 weiter verbessert.

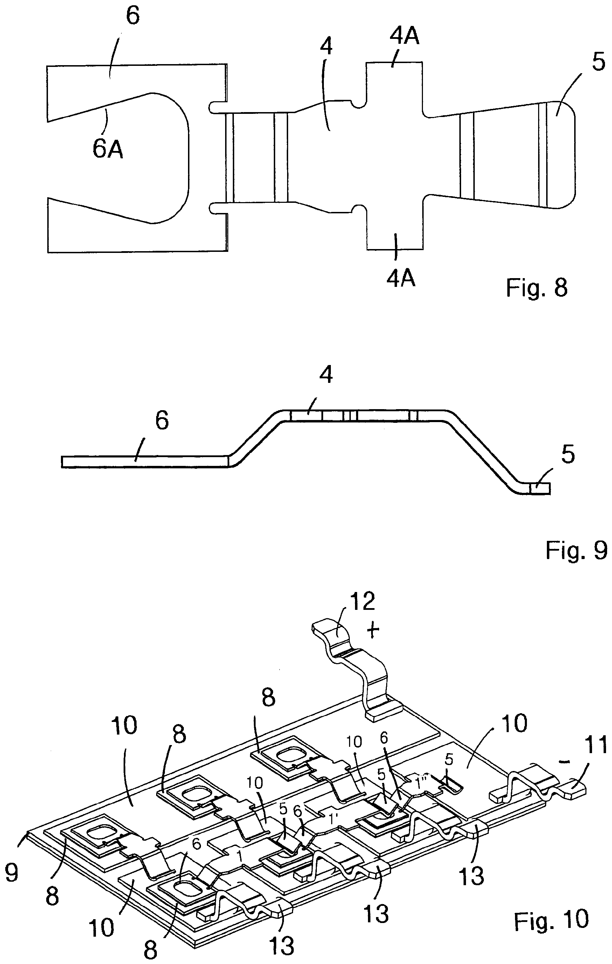

Die Schnittdarstellung von Fig. 9 zeigt, dass der erste flache Ansatz 5 des Kontaktelements 1 gegenüber dem zweiten plattenförmigen Ansatz 6 tiefer angesetzt ist, d. h. der Abstand zwischen dem ersten Ansatz 5 und dem Verbindungsstück 4 größer als der Abstand zwischen dem zweiten Ansatz 6 und dem Verbindungsstück 8 ist. Damit lassen sich Höhenunterschiede auf dem Substrat 9 ausgleichen.

Fig. 10 zeigt eine mögliche Anwendung des Kontaktelements 1 von den Figuren 7 bis 9 zur Kontaktierung der Dioden 8 auf der Plus-Seite des Substrats 9, wobei der tiefer liegende Ansatz 5 der Kontaktelemente 1 auf der tiefer liegenden Kontaktfläche der Metallisierung 10 und der höher liegende Ansatz 6 auf der höher liegenden Kontaktfläche der Diode (Chip) 8 aufliegt. Auf der Minus-Seite des Substrats 9 ergibt sich ein ähnlicher Anwendungsfall für das Kontaktelement 1", das eine der Dioden 8 mit der externen Anschlusslasche 11 elektrisch verbindet. Mit dem Kontaktelement 1" kann im Gegensatz zu dem Ausführungsbeispiel von Fig. 3 auf eine Landestelle auf der Anschlusslasche 11, die auf der Höhe der Kontaktfläche des Chips liegt, vermieden werden. Der tiefer liegende Ansatz 5 des Kontaktelements 1 erlaubt eine Kontaktierung auf der breiten flachen Kontaktfläche des Substrats 9, womit ebenfalls ein Lot-Preform eingespart wird.

## Patentansprüche

1. Leistungshalbleitermodul mit einem elektrische Kontaktflächen aufweisenden Träger (9), mindestens einem auf dem Träger (9) angeordneten Leistungshalbleiterbauteil (8) und mindestens zwei Kontaktelementen (1, 1', 1"), die jeweils einen ersten und einen zweiten Ansatz (5, 6) aufweisen, die elektrisch mit einer Kontaktfläche des mindestens einen Leistungshalbleiterbauteils (8) oder mit einer Kontaktfläche des Trägers (9) verbunden sind,
**dadurch gekennzeichnet, dass** die mindestens zwei Kontaktelemente (1) ein langgestrecktes Verbindungsstück (4) aufweisen, an dessen Enden der erste und der zweite Ansatz (5, 6) vorgesehen sind,
dass das langgestreckte Verbindungsstück (4) mit dem ersten und dem zweiten Ansatz (5, 6) als ein flaches, gebogenes Metallstück ausgebildet ist, wobei die Ansätze (5, 6) der mindestens zwei Kontaktelemente (1, 1', 1") derart ausgebildet sind, dass an einer Kontaktfläche des Leistungshalbleiterbauteils (8) oder des Trägers (9) der erste Ansatz (5) des einen Kontaktelements (1; 1') von dem zweiten Ansatz (6) des anderen Kontaktelements (1'; 1") umfangsmäßig zumindest teilweise umschlossen wird, und
dass der erste und der zweite Ansatz (5, 6) an das langgestreckte Verbindungsstück (4) nach einer Seite vorspringend angeformt sind.

2. Leistungshalbleitermodul nach Anspruch 1, **dadurch gekennzeichnet, dass** die Ansätze (5, 6) der mindestens zwei Kontaktelemente (1, 1', 1") derart ausgebildet sind, dass der erste Ansatz (5) des einen Kontaktelements (1; 1') in dem zweiten Ansatz (6) des anderen Kontaktelements (1'; 1") quer zur Längsrichtung der mindestens zwei Kontaktelemente (1, 1', 1") seitlich fixiert ist.

3. Leistungshalbleitermodul nach Anspruch 1 oder 2, **dadurch gekennzeichnet, dass** die Ansätze (5, 6) der mindestens zwei Kontaktelemente (1, 1', 1") derart ausgebildet sind, dass der erste Ansatz (5) des einen Kontaktelements (1; 1') in dem zweiten Ansatz (6) des anderen Kontaktelements (1'; 1") in Längsrichtung der mindestens zwei Kontaktelemente (1, 1', 1") lose geführt ist.

4. Leistungshalbleitermodul nach einem der Ansprüche 1 bis 3, **dadurch gekennzeichnet, . dass** das langgestreckte Verbindungsstück (4) mit dem ersten und zweiten Ansatz (5, 6) mit Weichlot beschichtet ist.

5. Leistungshalbleitermodul nach einem der Ansprüche 1 bis 4, **dadurch gekennzeichnet, dass** der erste Ansatz (5) der mindestens zwei Kontaktelemente (1, 1', 1") einen U-förmigen Querschnitt aufweist.

6. Leistungshalbleitermodul nach einem der Ansprüche 1 bis 5, **dadurch gekennzeichnet, dass** der zweite Ansatz (6) der mindestens zwei Kontaktelemente (1, 1', 1") ein plattenförmiger oder tellerförmiger Ansatz ist, der eine Ausnehmung (7) aufweist.

7. Leistungshalbleitermodul nach Anspruch 6, **dadurch gekennzeichnet, dass** die Ausnehmung (7) des zweiten Ansatzes (6) eine rechteckförmige Ausnehmung ist.

8. Leistungshalbleitermodul nach Anspruch 6 oder 7, **dadurch gekennzeichnet, dass** der zweite Ansatz (6) der mindestens zwei Kontaktelemente (1, 1', 1") in der Art eines Mauls ausgebildet ist.

9. Leistungshalbleitermodul nach einem der Ansprüche 1 bis 8, **dadurch gekennzeichnet, dass** die Ansätze (5, 6) der mindestens zwei Kontaktelemente (1, 1', 1") mit der Kontaktfläche der Leistungshalbleiter (8) oder des Trägers (9) verlötet sind.

10. Leistungshalbleitermodul nach einem der Ansprüche 1 bis 9, **dadurch gekennzeichnet, dass** der Träger ein Substrat (9) ist, das an mindestens einer Seite eine strukturierte Metallisierung (10) aufweist, insbesondere ein beidseitig metallisiertes Keramiksubstrat ist.

11. Leistungshalbleitermodul nach einem der Ansprüche 1 bis 10, **dadurch gekennzeichnet, dass** der Träger (9) ein gestanzter metallischer Träger ist.

12. Leistungshalbleitermodul nach einem der Ansprüche 1 bis 11, **dadurch gekennzeichnet, dass** das Leitungshalbleitermodul ein den Träger (9) zumindest teilweise umschließendes Gehäuse (14) aufweist, aus dem Anschlüsse (11, 12, 13) herausgeführt sind, die mit einer Kontaktfläche des mindesten einen Leistungshalbleiterbauteils (8) oder einer Kontaktfläche des Trägers elektrisch verbunden sind.

## Claims

1. A power semiconductor module comprising a support (9) with electric contact surfaces, at least one power semiconductor component (8) located on the support (9) and at least two contact elements (1, 1', 1"), which each have a first and a second lug (5, 6), which are electrically connected to a contact surface of the at least one power semiconductor component (8) or to a contact surface of the support (9),
**characterised in that** the at least two contact elements (1) have an elongated connecting portion (4) at the ends of which the first and the second lug (5, 6) are provided,
**in that** the elongated connecting portion (4) with the first and second lugs (5, 6) is designed as a flat, bent metal piece, wherein the lugs (5, 6) of the at least two contact elements (1, 1', 1") are designed such that on one contact surface of the power semiconductor component (8) or of the support (9) the first lug (5) of the one contact element (1; 1') is at least partially surrounded around the circumference by the second lug (6) of the other contact element (1'; 1"), and
**in that** the first and second lugs (5, 6) are shaped onto the elongated connecting portion (4) so that they protrude to one side.

2. The power semiconductor module according to claim 1, **characterised in that** the lugs (5, 6) of the at least two contact elements (1, 1', 1") are designed such that the first lug (5) of the one contact element (1; 1') is fixed laterally into the second lug (6) of the other contact element (1'; 1") crosswise to the longitudinal direction of the at least two contact elements (1, 1', 1").

3. The power semiconductor module according to claim 1 or 2, **characterised in that** the lugs (5, 6) of the at least two contact elements (1, 1', 1") are designed such that the first lug (5) of the one contact element (1; 1') is loosely positioned into the second lug (6) of the other contact element (1'; 1") in the longitudinal direction of the at least two contact elements (1, 1', 1").

4. The power semiconductor module according to one of claims 1 to 3, **characterised in that** the elongated connecting portion (4) with the first and second lugs (5, 6) is coated with soft solder.

5. The power semiconductor module according to one of claims 1 to 4, **characterised in that** the first lug (5) of the at least two contact elements (1, 1', 1") has a U-shaped cross-section.

6. The power semiconductor module according to one of claims 1 to 5, **characterised in that** the second lug (6) of the at least two contact elements (1, 1', 1") is a plate-shaped or dishshaped lug with a recess (7).

7. The power semiconductor module according to claim 6, **characterised in that** the recess (7) of the second lug (6) is a rectangular recess.

8. The power semiconductor module according to claim 6 or 7, **characterised in that** the second lug (6) of the at least two contact elements (1, 1', 1") is designed in the form of a jaw.

9. The power semiconductor module according to one of claims 1 to 8, **characterised in that** the lugs (5, 6) of the at least two contact elements (1, 1', 1") are soldered to the contact surface of the power semiconductor (8) or of the support (9).

10. The power semiconductor module according to one of claims 1 to 9, **characterised in that** the support is a substrate (9) which has a structured metal plating (10) on at least one side, and in particular is a ceramic substrate with metal plating on both sides.

11. The power semiconductor module according to one of claims 1 to 10, **characterised in that** the support (9) is a punched metallic support.

12. The power semiconductor module according to one of claims 1 to 11, **characterised in that** the power semiconductor module has a housing (14) surrounding the support (9) at least in part, out of which housing connections (11, 12, 13) are routed which are electrically connected to a contact surface of the at least one power semiconductor component (8) or a contact surface of the support.

## Revendications

1. Module semi-conducteur de puissance comprenant : un support (9) présentant des surfaces de contact électrique, au moins un composant semi-conducteur de puissance (8) disposé sur le support (9), et au moins deux éléments de contact (1, 1', 1") présentant chacun une première et une deuxième embase (5, 6) en liaison électrique avec une surface de contact de l'au moins un composant semi-conducteur de puissance (8) ou une surface de contact du support (9),
**caractérisé en ce que** les au moins deux éléments de contact (1) présentent une partie de liaison allongée (4) aux extrémités de laquelle sont prévues la première et la deuxième embase (5, 6),
**en ce que** la partie de liaison allongée (4) comportant la première et la deuxième embase (5, 6) est conçue sous la forme d'une pièce métallique plate et à recourbements, lesdites embases (5, 6) des au moins deux éléments de contact (1, 1', 1") étant conçues de façon que, sur une surface de contact du composant semi-conducteur de puissance (8) ou du support (9), la première embase (5) d'un élément de contact (1 ; 1') est entourée au moins partiellement sur son pourtour par la deuxième embase (6) de l'autre élément de contact (1' ; 1"), et
**en ce que** la première et la deuxième embase (5, 6) sont formées sur la partie de liaison allongée (4) en faisant saillie sur un côté.

2. Module semi-conducteur de puissance selon la revendication 1, **caractérisé en ce que** les embases (5, 6) des au moins deux éléments de contact (1, 1', 1") sont conçues de façon que la première embase (5) dudit un élément de contact (1 ; 1') soit fixée latéralement dans la deuxième embase (6) dudit autre élément de contact (1' ; 1") transversalement au sens longitudinal des au moins deux éléments de contact (1, 1', 1").

3. Module semi-conducteur de puissance selon la revendication 1 ou 2, **caractérisé en ce que** les embases (5, 6) des au moins deux éléments de contact (1, 1', 1") sont conçues de façon que la première embase (5) d'un élément de contact (1 ; 1') soit introduite de manière lâche dans la deuxième embase (6) de l'autre élément de contact (1' ; 1") dans le sens longitudinal des au moins deux éléments de contact (1, 1', 1").

4. Module semi-conducteur de puissance selon l'une des revendications 1 à 3, **caractérisé en ce que** la partie de liaison allongée (4) comportant la première et la deuxième embase (5, 6) est revêtue de brasure tendre.

5. Module semi-conducteur de puissance selon l'une des revendications 1 à 4, **caractérisé en ce que** la première embase (5) des au moins deux éléments de contact (1, 1', 1") présente une section transversale en forme d'U.

6. Module semi-conducteur de puissance selon l'une des revendications 1 à 5, **caractérisé en ce que** la deuxième embase (6) des au moins deux éléments de contact (1, 1', 1") est une embase en forme de plaque ou d'assiette présentant un évidement (7).

7. Module semi-conducteur de puissance selon la revendication 6, **caractérisé en ce que** l'évidement (7) de la deuxième embase (6) est rectangulaire.

8. Module semi-conducteur de puissance selon la revendication 6 ou 7, **caractérisé en ce que** la deuxième embase (6) des au moins deux éléments de contact (1, 1', 1") est conçue à la manière d'une gueule.

9. Module semi-conducteur de puissance selon l'une des revendications 1 à 8, **caractérisé en ce que** les embases (5, 6) des au moins deux éléments de contact (1, 1', 1") sont soudées à la surface de contact du semi-conducteur de puissance (8) ou du support (9).

10. Module semi-conducteur de puissance selon l'une des revendications 1 à 9, **caractérisé en ce que** le support est un substrat (9) présentant, sur au moins une face, une métallisation structurée (10), notamment un substrat en céramique métallisé sur les deux faces.

11. Module semi-conducteur de puissance selon l'une des revendications 1 à 10, **caractérisé en ce que** le support (9) est un support métallique poinçonné.

12. Module semi-conducteur de puissance selon l'une des revendications 1 à 11, **caractérisé en ce que** le module semi-conducteur de puissance présente un boîtier (14) renfermant au moins partiellement le support (9) et duquel sortent des bornes (11, 12, 13) qui sont en liaison électrique avec une surface de contact de l'au moins un composant semi-conducteur de puissance (8) ou une surface de contact du support.
